# EUROPEAN PATENT APPLICATION

(11) **EP 4 637 305 A1**
(43) Date of publication of application: **22.10.2025**
(21) Application number: 24835252.8
(22) Date of filing: 24.06.2024
(51) Int. Cl.: H10F 77/30, H10F 71/00, H10F 19/80

(54) **CELL, PHOTOVOLTAIC MODULE, AND PACKAGING METHOD FOR CELL**

(30) Priority: 04.07.2023 CN 202310814645; 04.07.2023 CN 202321742101 U
(71) Applicant: Longi Solar Technology (Taizhou) Co., Ltd., Taizhou, Jiangsu 225300 (CN)
(72) Inventor: TONG, Hongbo, Taizhou, Jiangsu 225300 (CN); CHEN, Cheng, Taizhou, Jiangsu 225300 (CN); LIANG, Zhu, Taizhou, Jiangsu 225300 (CN); LI, Hua, Taizhou, Jiangsu 225300 (CN); WANG, Pengbin, Taizhou, Jiangsu 225300 (CN); LI, Jinyu, Taizhou, Jiangsu 225300 (CN); WANG, Dewei, Taizhou, Jiangsu 225300 (CN); YU, Ping, Taizhou, Jiangsu 225300 (CN)
(74) Representative: Pfenning, Meinig & Partner mbB
(86) International application number: PCT/CN2024/101075
(87) International publication number: WO 2025/007770

(57) **Abstract**

The present disclosure provides a solar cell, a photovoltaic module, and a method for packaging a solar cell. The solar cell is a back contact solar cell. Because a protective layer covers a light-receiving surface of the solar cell, the light-receiving surface of the solar cell can be prevented from being scratched due to stacked transportation of solar cells, and a separator paper does not need to be placed between two adjacent solar cells, reducing a failure rate of a production line.

## Description

### CROSS-REFERENCE TO RELATED APPLICATIONS

This application claims priority to Chinese Patent Application No. 202310814645.8, entitled "METHOD FOR PACKAGING SOLAR CELL, SOLAR CELL, AND PHOTOVOLTAIC MODULE" filed with the China National Intellectual Property Administration on July 04, 2023, and claims priority to Chinese Patent Application No. 202321742101.7", entitled "SOLAR CELL AND PHOTOVOLTAIC MODULE" filed with the China National Intellectual Property Administration on July 04, 2023, which are incorporated by reference in their entireties.

### TECHNICAL FIELD

The present disclosure relates to the field of solar cell technologies, and specifically, to a solar cell, a photovoltaic module, and a method for packaging a solar cell.

### BACKGROUND

An interdigitated back contact (IBC) solar cell is a solar cell in which both emitting region electrodes and base region electrodes are located on a back surface. Currently, during storage and transportation of back contact solar cells, a plurality of back contact solar cells are directly stacked. Because electrodes on a back surface of one of the back contact solar cells are in direct contact with a light-receiving surface of an adjacent back contact solar cell, the light-receiving surface is prone to friction and scratching. As a result, light absorption by the back contact solar cell is reduced, reducing photoelectric conversion performance of the solar cell.

In the related art, to reduce a possibility that a light-receiving surface of a solar cell is scratched due to stacked transportation of solar cells, an operator usually places a separator paper between two adjacent solar cells. However, the inventor finds that such a method has at least the following problems:
It is difficult to take out the separator paper, and it is easy to bring the separator paper into a production line to cause a failure; and
the separator paper has low utilization and high consumption, resulting in an increase in costs.

### SUMMARY

The present disclosure provides a solar cell, a photovoltaic module, and a method for packaging a solar cell, to resolve or at least partially resolve problems in the related art.

Technical solutions in the present disclosure are as follows:
The present disclosure provides a solar cell. The solar cell is a back contact solar cell. A protective layer is arranged on a light-receiving surface of the solar cell. Light transmittance of the protective layer being greater than a light transmittance threshold. A heat-resistant temperature of the protective layer is greater than or equal to a heat-resistant temperature threshold.

In an embodiment, a bonding layer is arranged between the protective layer and the light-receiving surface of the solar cell. A first surface of the protective layer is bonded to a first surface of the bonding layer, and a second surface of the bonding layer is bonded to the light-receiving surface of the solar cell.

In an embodiment, the bonding layer includes a plurality of bonding parts. The bonding parts are distributed in an entire region or a partial region of the light-receiving surface.

In an embodiment, a thickness range of the bonding layer is 5 µm to 10 µm.

In an embodiment, a material of the protective layer is one of a polyethylene glycol terephthalate material and a photosensitive adhesive material.

In an embodiment, when a material of the protective layer is a photosensitive adhesive material, the protective layer is formed by a cured photosensitive adhesive material; and/or a material of the bonding layer is an ethylene vinyl acetate copolymer.

In an embodiment, at least one surface of the protective layer is a frosted surface. A thickness of the protective layer ranges from 30 µm to 60 µm. A roughness of a first surface of the protective layer ranges from 0.4 mm to 1.0 mm; and/or a roughness of a second surface of the protective layer ranges from 0.4 mm to 1.0 mm.

In an embodiment, a hardness of the protective layer ranges from 55 HD to 85 HD. The light transmittance threshold is 95%; and/or the heat-resistant temperature threshold is 160°C or 200°C.

The present disclosure further provides a photovoltaic module, including the foregoing solar cell.

The present disclosure further provides a method for packaging a solar cell. A solar cell is a back contact solar cell. The method includes: A protective layer is arranged on a light-receiving surface of the solar cell. Light transmittance of the protective layer is greater than a light transmittance threshold. A heat-resistant temperature of the protective layer is greater than or equal to a heat-resistant temperature threshold.

In an embodiment, that a protective layer is arranged on a light-receiving surface of the solar cell includes: A coating is formed on the light-receiving surface of the solar cell, a material of the coating being a polymer material. Light transmittance of the polymer material is greater than the light transmittance threshold, and a heat-resistant temperature of the polymer material is greater than or equal to the heat-resistant temperature threshold. The coating is cured, to form the protective layer of the light-receiving surface of the solar cell.

In an embodiment, that a coating is formed on the light-receiving surface of the solar cell includes: The polymer material is heated to a first preset temperature to be melted into a liquid state, to form a spray material. The first preset temperature is greater than the heat-resistant temperature. The spray material is sprayed to form the coating on the light-receiving surface according to a first preset pressure. The heat-resistant temperature is 255°C. The first preset pressure ranges from 0.4 kilogram-force to 0.6 kilogram-force.

In an embodiment, that the coating is cured, to form the protective layer of the light-receiving surface of the solar cell includes: The coating is cured, to form the protective layer at a second preset temperature and first curing duration. The first curing duration ranges from 10s to 15s, and the second preset temperature ranges from 5°C to 15°C.

In an embodiment, that the spray material is sprayed to form the coating on the light-receiving surface according to a first preset pressure includes: The spray material is sprayed on the light-receiving surface according to the first preset pressure, and the spray material on the light-receiving surface is formed as the coating when a thickness of the spray material on the light-receiving surface ranges from 30 µm to 60 µm.

In an embodiment, the polymer material is a photosensitive adhesive material. That a coating is formed on the light-receiving surface of the solar cell includes: The photosensitive adhesive material is sprayed to form the coating on the light-receiving surface according to a second preset pressure. The second preset pressure ranges from 0.4 kilogram-force to 0.6 kilogram-force. Alternatively, the photosensitive adhesive material is printed to form the coating on the light-receiving surface according to a third preset pressure through screen printing. The third preset pressure ranges from 50 N to 60 N.

In an embodiment, that the coating is cured, to form the protective layer of the light-receiving surface of the solar cell includes: The coating is cured under ultraviolet irradiation based on second curing duration, to form the protective layer. The second curing duration ranges from 2s to 3s.

In an embodiment, that the coating is cured, to form the protective layer of the light-receiving surface of the solar cell includes: The coating is cured, and the coating is formed as the protective layer when a hardness of a surface of the coating formed in a solid state falls within a hardness range and a thickness of the coating formed in the solid state falls within a thickness range. Alternatively, the coating is cured, and a roughness of a surface of the coating formed in a solid state is determined when it is determined that a hardness of the surface of the coating formed in the solid state falls within a hardness range and a thickness of the coating formed in the solid state falls within a thickness range; and the coating is formed as the protective layer when the roughness of the surface of the coating formed in the solid state falls within a roughness range. The hardness range is 55 HD to 85 HD. The thickness range is 30 µm to 60 µm. The roughness range is 0.4 mm to 1 mm.

In an embodiment, the protective layer is a film, and a material of the protective layer is a polyethylene glycol terephthalate material or a photosensitive adhesive material. That a protective layer is arranged on a light-receiving surface of the solar cell includes: The protective layer is obtained, and a bonding layer is formed on the protective layer. The protective layer is arranged on the light-receiving surface of the solar cell through the bonding layer.

In an embodiment, that a bonding layer is formed on the protective layer includes: An adhesive is sprayed to form an adhesive coating on the protective layer. The adhesive coating is heated to form the bonding layer at a third preset temperature and preset duration. The preset duration ranges from 1s to 3s, and the third preset temperature ranges from 90°C to 120°C.

In an embodiment, that the protective layer is arranged on the light-receiving surface of the solar cell through the bonding layer includes: The protective layer is placed on the light-receiving surface of the solar cell through the bonding layer, to cause the bonding layer to be arranged between the protective layer and the light-receiving surface of the solar cell. The protective layer is pressed based on a pressing pressure, to cause the protective layer to be bonded to the light-receiving surface of the solar cell through the bonding layer. The pressing pressure ranges from 30 N to 50 N.

The present disclosure provides a solar cell. The solar cell is a back contact solar cell. Because a protective layer covers a light-receiving surface of the solar cell, the light-receiving surface of the solar cell can be prevented from being scratched due to stacked transportation of solar cells, and a separator paper does not need to be placed between two adjacent solar cells, reducing a failure rate of a production line.

### BRIEF DESCRIPTION OF THE DRAWINGS

The accompanying drawings are used for better understanding of the present disclosure, and do not constitute an inappropriate limitation to the present disclosure.
FIG. 1 is a partial schematic side view of a solar cell according to an embodiment of the present disclosure;
FIG. 2 is a schematic diagram of a solar cell according to an embodiment of the present disclosure;
FIG. 3 is a schematic structural diagram of a solar cell according to an embodiment of the present disclosure;
FIG. 4 is a schematic structural diagram of a photovoltaic module according to an embodiment of the present disclosure;
FIG. 5 is a flowchart of steps of a method for packaging a solar cell according to an embodiment of the present disclosure;
FIG. 6 is a flowchart of specific steps of a method for packaging a solar cell according to an embodiment of the present disclosure; and
FIG. 7 is a flowchart of specific steps of another method for packaging a solar cell according to an embodiment of the present disclosure.

Reference numerals:
10-solar cell; 11-protective layer; 111-first surface of the protective layer; 112-second surface of the protective layer; 12-bonding layer; 121-first surface of the bonding layer; 122-second surface of the bonding layer; 13-light-receiving surface; 14-back surface; 15-electrode; 21-glass layer; 22-first adhesive layer; 23-second adhesive layer; 24-back sheet; 25-outer frame; and 26-junction box.

### DETAILED DESCRIPTION

Exemplary embodiments of the present disclosure are described below. Various details of some embodiments are included to facilitate understanding. The details should be considered as only exemplary. Therefore, a person of ordinary skill in the art should recognize that various changes and modifications can be made to the embodiments described herein without departing from the scope and spirit of the present disclosure. Similarly, for clarity and conciseness, descriptions of well-known functions and structures are omitted in the following descriptions.

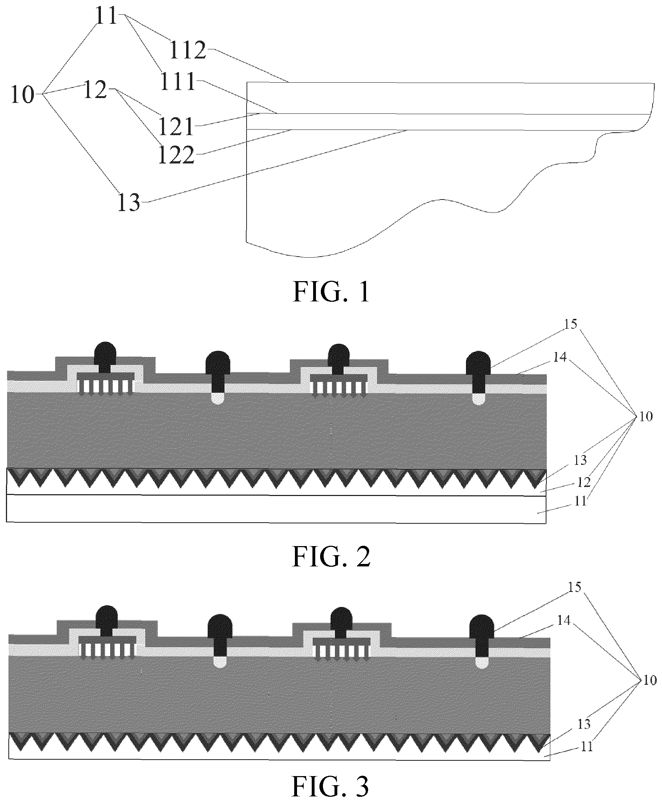

Referring to FIG. 1, the present disclosure provides a solar cell 10. The solar cell 10 is a back contact solar cell. A protective layer 11 is arranged on a light-receiving surface 13 of the solar cell 10. Light transmittance of the protective layer 11 is greater than a light transmittance threshold. A heat-resistant temperature of the protective layer 11 is greater than or equal to a heat-resistant temperature threshold.

In some embodiments, a bonding layer 12 and the protective layer 11 are sequentially arranged on the light-receiving surface 13 of the solar cell 10. The light transmittance of the protective layer 11 is greater than the light transmittance threshold. The heat-resistant temperature of the protective layer 11 is greater than or equal to the heat-resistant temperature threshold. A first surface 111 of the protective layer 11 is bonded to a first surface 121 of the bonding layer 12, and a second surface 122 of the bonding layer 12 is bonded to the light-receiving surface 13 of the solar cell 10.

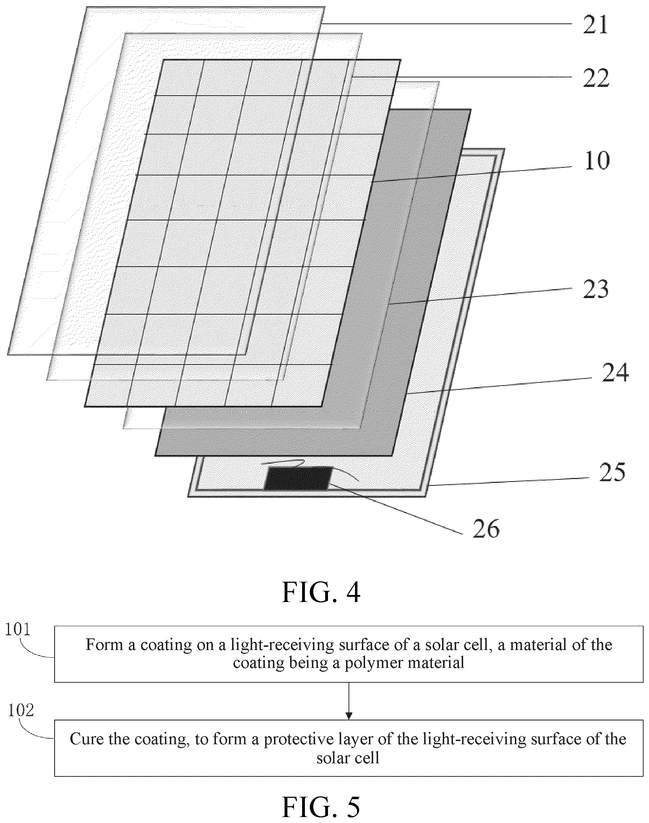

It should be noted that, referring to FIG. 4, a photovoltaic module (a solar cell module) using the back contact solar cell includes, according to an order from a front surface to a back surface, a glass layer 21, a first adhesive layer 22, a series group of solar cells 10, a second adhesive layer 23, a back sheet 24, and an outer frame 25. The glass layer 21 is generally tempered glass. Due to good light transmittance performance and a high hardness, the tempered glass can adapt to a large day-night temperature difference and an adverse weather environment, and is configured to cover a solar cell 10 to protect the solar cell 10. A material of the first adhesive layer 22 and a material of the second adhesive layer 23 are generally an ethylene vinyl acetate copolymer (EVA). The first adhesive layer 22 is configured to bond the solar cell 10 to the glass. The second adhesive layer 23 is configured to bond a solar cell 10 to the back sheet 24. The series group of solar cells 10 includes a plurality of solar cells 10. The solar cell 10 is a back contact solar cell, is a core component of the photovoltaic module, and is configured to generate power by using solar energy. The back sheet 24 is generally a TPT back sheet 24. The TPT back sheet 24 is a back sheet 24 formed by three films of polyvinyl-fluoride (PVF)-polyethylene glycol terephthalate (PET)-PVF. Due to sealing, insulation, waterproofing, and aging resistance functions, the back sheet 24 can protect the solar cell 10, thereby prolonging the service life of the photovoltaic module. The outer frame 25 is generally an aluminum-alloy outer frame 25. Due to good strength and corrosion resistance, the aluminum-alloy outer frame 25 can support and protect the solar cell 10.

In addition, the photovoltaic module further includes a junction box 26 arranged on the aluminum-alloy outer frame 25. The junction box 26 protects a power generation system of the entire solar cell 10, and seals and waterproof a lead wire of the photovoltaic module. In addition, when a short circuit occurs in a solar cell 10, the junction box 26 automatically disconnects a series group of the short-circuited solar cell 10.

A production process of the photovoltaic module using the back contact solar cell includes the following steps: (1) Solar cell test. To be specific, solar cells 10 are classified by testing values of output parameters (currents and voltages) of the solar cells 10, to combine solar cells 10 having consistent or similar performance. (2) Transportation. To be specific, stacked solar cells 10 are transported to a subsequent production line of the photovoltaic module. (3) Green glue and gray glue printing on a back surface. To be specific, green glue and gray glue printing on the back surface is performed on electrodes 15 on a back surface 14 of the solar cell 10. (4) Back surface stringing. To be specific, a plurality of solar cells 10 are welded together in series to form a series group of the solar cells 10. (5) Stacking. To be specific, the glass layer 21, the first adhesive layer 22, the series group of solar cells 10, the second adhesive layer 23, and the back sheet 24 are sequentially stacked. (6) Lamination. To be specific, the glass layer 21, the first adhesive layer 22, the series group of solar cells 10, the second adhesive layer 23, and the back sheet 24 that are stacked are placed in a laminating machine, and the module is evacuated. Then, the first adhesive layer 22 and the second adhesive layer 23 are melted through heating, to bond the glass layer 21, the series group of solar cells 10, and the back sheet 24 together, to form an initial photovoltaic module. Finally, the initial photovoltaic module is taken out after cooling. A protective layer 11 of the solar cell 10, the first adhesive layer 22, and the glass layer 21 are fused to form an interface. This satisfies a requirement for light transmittance, and the protective layer does not need to be removed, thereby improving production efficiency. (7) Photovoltaic module test. To be specific, power of the photovoltaic module is mainly tested. (8) Assembling. To be specific, the outer frame 25 is mounted, the junction box 26 is connected, and the like.

From the perspective of a material type of the solar cell, the solar cell 10 provided in this embodiment of the present disclosure is generally a monocrystalline silicon solar cell. Photoelectric conversion efficiency of the monocrystalline silicon solar cell can reach 28.7%. In addition, the solar cell 10 provided in this embodiment of the present disclosure is alternatively a heterojunction solar cell. Photoelectric conversion efficiency of the heterojunction solar cell can reach 29.4%.

Referring to FIG. 2, the solar cell 10 provided in this embodiment of the present disclosure further includes a back surface 14. Electrodes 15 are arranged on the back surface 14. Types of the electrodes 15 include a positive electrode and a negative electrode.

In this embodiment of the present disclosure, because the protective layer 11 covers the light-receiving surface 13 of the solar cell 10, the light-receiving surface 13 of the solar cell 10 can be prevented from being scratched due to stacked transportation of the solar cells 10, and a separator paper does not need to be placed between two adjacent solar cells 10. In this way, a failure rate of the production line is reduced, and the following problem is resolved: During production of the photovoltaic module in the related art, the separator paper is placed between two adjacent solar cells 10 to prevent the light-receiving surface 13 of the solar cell 10 from being scratched due to stacked transportation of the solar cells 10, causing a failure because the separator paper is brought into the production line. In addition, in the lamination process of the photovoltaic module, the protective layer, the adhesive layer, and the glass are fused to form a complete interface. This satisfies the requirement for light transmittance, and the protective layer does not need to be removed, thereby improving the production efficiency.

Specifically, in some embodiments, the bonding layer 12 is an adhesive, for example, an adhesive of an EVA material. The protective layer 11 is a film, and no bubble exists inside the protective layer 11.

The adhesive of the EVA material is an EVA composite adhesive. The EVA composite adhesive is a type of glue. Main components of the EVA composite adhesive are thermal plastic styrene-butadiene rubber, rosin modified resin, petroleum resin, and a solvent. The EVA composite adhesive has a good bonding effect and long aging time, does not need to process water, and is applied once, so that the EVA composite adhesive is more conveniently used, and the production efficiency is higher. A curing object bonded by using the EVA composite adhesive has super strong flexibility, can bear severe beating and falling, and is not easy to flake off, so that the EVA composite adhesive has a good cushioning property. The EVA composite adhesive has a low odor, and satisfies an environmental protection standard and a health standard. In addition, the EVA composite adhesive has high strength, high transparency, and high initial adhesion.

In this embodiment of the present disclosure, the bonding layer of the EVA composite adhesive can cause the protective layer to be more firmly bonded to the light-receiving surface of the solar cell.

It should be noted that, both the first surface 121 and the second surface of the bonding layer 12 are flat surfaces, and a shape of the second surface 122 of the bonding layer 12 is the same as a shape of the first surface 121 of the bonding layer 12. Both the first surface 111 and the second surface 112 of the protective layer 11 are flat surfaces, and a shape of the first surface 111 of the protective layer 11 is the same as a shape of the second surface 112 of the protective layer 11.

In some embodiments, at least one surface of the protective layer 11 is a frosted surface.

In this embodiment of the present disclosure, because the at least one surface of the protective layer 11 is the frosted surface, an interface formed by contact between the frosted surface and another surface reduces a degree of specular reflection generated on light and improves light transmittance.

In some embodiments, the first surface 111 and the second surface of the protective layer 11 are frosted surfaces.

In this embodiment of the present disclosure, because the first surface 111 of the protective layer 11 is bonded to the first surface 121 of the bonding layer 12 and the first surface 111 of the protective layer 11 is the frosted surface, an interface formed by the first surface 111 of the protective layer 11 and the first surface 121 of the bonding layer 12 reduces the degree of specular reflection generated on light and improves the light transmittance. In the lamination process during production of the photovoltaic module, the first adhesive layer 22 of the adhesive of the EVA material is arranged on the protective layer 11 of the solar cell 10, to bond the solar cell 10 to a glass sheet. Because the second surface 112 of the protective layer 11 is in contact with the first adhesive layer 22 and the second surface 112 of the protective layer 11 is the frosted surface, an interface formed by contact between the second surface 112 of the protective layer 11 and the first adhesive layer 22 reduces the degree of specular reflection generated on light and improves the light transmittance.

It should be noted that, an entire region of the first surface 111 of the protective layer 11 is the frosted surface; and an entire region of the second surface 112 of the protective layer 11 is the frosted surface.

In some embodiments, a roughness of the first surface 111 of the protective layer 11 ranges from 0.4 mm to 1.0 mm; and/or a roughness of the second surface 112 of the protective layer 11 ranges from 0.4 mm to 1.0 mm.

In this embodiment of the present disclosure, because the roughness of the first surface 111 of the protective layer 11 ranges from 0.4 mm to 1.0 mm, it is ensured that the interface formed by the first surface 111 of the protective layer 11 and the first surface 121 of the bonding layer 12 can reduce the degree of specular reflection generated on light and improve the light transmittance. In the lamination process during production of the photovoltaic module, the first adhesive layer 22 of the adhesive of the EVA material is arranged on the protective layer 11 of the solar cell 10, to bond the solar cell 10 to a glass sheet. In the lamination process of the photovoltaic module, the second surface 112 is filled with liquid EVA in contact with the second surface 112, so that the protective layer 11, the first adhesive layer 22 of the EVA, and the glass layer 21 finally form a complete interface. Because the second surface 112 of the protective layer 11 is the frosted surface, a contact surface between the second surface 112 and the first adhesive layer of the EVA in the lamination process of the photovoltaic module can be enlarged, making the protective layer more firmly bonded to the glass.

Specifically, in some embodiments, the roughness of the first surface 111 of the protective layer 11 is 0.4, 0.5, 0.6, 0.7, 0.8, 0.9, 1.0, or the like; and the roughness of the second surface 112 of the protective layer 11 is 0.4, 0.5, 0.6, 0.7, 0.8, 0.9, 1.0, or the like.

In some embodiments, the protective layer 11 covers the entire light-receiving surface 13 of the solar cell 10.

In this embodiment of the present disclosure, because the protective layer 11 covers the entire light-receiving surface 13 of the solar cell 10, the entire light-receiving surface 13 of the solar cell 10 can be protected, reducing a possibility that the light-receiving surface 13 of the solar cell 10 is scratched due to stacked transportation of the solar cells 10.

It should be noted that, the shape of the second surface 112 of the protective layer 11 is the same as a shape of the light-receiving surface 13 of the solar cell 10, so that the protective layer 11 covers the entire light-receiving surface 13 of the solar cell 10.

In some embodiments, the bonding layer 12 includes a plurality of bonding parts. The bonding parts are evenly or unevenly distributed in an entire region or a partial region of the light-receiving surface 13.

In this embodiment of the present disclosure, the bonding layer 12 includes the plurality of bonding parts, where the bonding parts are evenly distributed in the entire region or a partial region of the light-receiving surface 13. Therefore, balance of bonding force between the protective layer 11 and the light-receiving surface 13 can be ensured, thereby improving the firmness of the bonding between the protective layer 11 and the light-receiving surface 13.

It should be noted that, the first surface 121 of the bonding layer 12 includes first surfaces of the plurality of bonding parts; and the second surface 122 of the bonding layer 12 includes second surfaces of the plurality of bonding parts.

Specifically, in some embodiments, a shape of each of the bonding parts is the same or different, and the bonding part is rectangular, circular, triangular, or in another shape. One, two, three, four, or the like bonding parts are provided.

For example, when the light-receiving surface 13 of the solar cell 10 is rectangular, the bonding layer 12 includes one rectangular bonding part, where the bonding part is located in a central region of the light-receiving surface 13. In other words, a geometrical center of a second surface of the bonding part coincides with a geometrical center of the light-receiving surface 13, and each edge of the second surface of the bonding part is parallel to a corresponding edge of the light-receiving surface 13. Alternatively, the bonding layer 12 includes two identical rectangular bonding parts, where the two bonding parts are symmetrically distributed relative to a center line of the light-receiving surface 13. Alternatively, the bonding layer 12 includes three identical rectangular bonding parts, where two of the bonding parts are symmetrically distributed relative to the center line of the light-receiving surface 13, a geometrical center of a second surface of the other one of the bonding parts coincides with the geometrical center of the light-receiving surface 13, and one edge of the second surface of the other one of the bonding parts is parallel to the center line of the light-receiving surface 13. Alternatively, the bonding layer 12 includes four identical rectangular bonding parts, where the four bonding parts are respectively located in four corner regions of the light-receiving surface 13.

In some other embodiments, the bonding layer 12 includes N×M bonding parts. The bonding parts are evenly distributed on the light-receiving surface 13 of the solar cell 10 in a form of an array, where N is a quantity of bonding parts in a first direction of the array, M is a quantity of bonding parts in a second direction of the array, and an angle between the first direction and the second direction is 90°. A shape of each of the bonding parts is the same or different, and the bonding part is rectangular, circular, triangular, or in another shape.

For example, when the light-receiving surface 13 of the solar cell 10 is rectangular, the bonding layer 12 includes 20×30 circular bonding parts. To be specific, the 20×30 circular bonding parts form an even array on the light-receiving surface 13, where each row of the array in a direction of a first edge of the light-receiving surface 13 has 20 bonding parts, each column of the array in a direction of a second edge of the light-receiving surface 13 has 30 bonding parts, and an angle between a first direction and a second direction is 90°.

When the shape of the second surface 122 (that is, a flat surface formed by second surfaces of all bonding parts) of the bonding layer 12 is the same as the shape of the light-receiving surface 13 of the solar cell 10, the bonding parts are evenly distributed in the entire region of the light-receiving surface 13. When an area of the second surface 122 (that is, a flat surface formed by second surfaces of all bonding parts) of the bonding layer 12 is smaller than an area of the light-receiving surface 13 of the solar cell 10, the bonding parts are evenly distributed in a partial region of the light-receiving surface 13.

In some embodiments, the bonding layer 12 covers the entire light-receiving surface 13 of the solar cell 10.

It should be noted that, when the bonding layer 12 covers the entire light-receiving surface 13 of the solar cell 10, the shape of the first surface 111 of the protective layer 11 is the same as the shape of the first surface 121 of the bonding layer 12.

In this embodiment of the present disclosure, because the bonding layer 12 covers the entire light-receiving surface 13 of the solar cell 10, it can be ensured that the entire first surface of the protective layer 11 is bonded to the entire light-receiving surface 13 of the solar cell 10. In this way, the firmness of the bonding between the first surface 111 of the protective layer 11 and the light-receiving surface 13 of the solar cell 10 is enhanced, and the appearance and texture of the light-receiving surface 13 of the solar cell 10 are also even, thereby improving the aesthetics.

In some embodiments, a thickness range of the protective layer 11 is 30 µm to 60 µm.

In this embodiment of the present disclosure, because the thickness range of the protective layer 11 is 30 µm to 60 µm, the protective layer 11 is thinned, thereby satisfying a requirement for thinning the solar cell 10.

Specifically, in some embodiments, a thickness of the protective layer 11 is 30 µm, 35 µm, 40 µm, 45 µm, 50 µm, 55 µm, 60 µm, or the like.

In some embodiments, a thickness range of the bonding layer 12 is 5 µm to 10 µm.

In this embodiment of the present disclosure, because the thickness range of the bonding layer 12 is 5 µm to 10 µm, the bonding layer 12 is thinned, thereby satisfying a requirement for thinning the solar cell 10.

Specifically, in some embodiments, a thickness of the bonding layer 12 is 5 µm, 6 µm, 7 µm, 8 µm, 9 µm, or 10 µm.

In some embodiments, the light transmittance threshold is 95%.

In this embodiment of the present disclosure, the light transmittance of the protective layer 11 is greater than the light transmittance threshold, and the light transmittance threshold is 95%, that is, the light transmittance of the protective layer 11 is greater than 95%. Therefore, the protective layer 11 has good light transmittance, thereby satisfying a requirement of the solar cell 10 for good light transmittance.

Specifically, in some embodiments, the light transmittance of the protective layer 11 is 96%, 97%, 98%, 99%, or the like.

In some embodiments, a material of the protective layer 11 includes one of a polyethylene glycol terephthalate material and a photosensitive adhesive material; and/or a material of the bonding layer is an ethylene vinyl acetate copolymer.

In some embodiments, the heat-resistant temperature threshold is 160°C.

Because a protective layer made of a material with a low melting point (for example, EVA whose melting point ranges from 60°C to 110°C) is prone to melting during production of the photovoltaic module, the solar cell sticks to a production device, affecting normal production of the photovoltaic module. In this embodiment of the present disclosure, the heat-resistant temperature of the protective layer 11 is greater than the heat-resistant temperature threshold, to be specific, the heat-resistant temperature of the protective layer 11 (that is, a melting point of the protective layer 11) is greater than the heat-resistant temperature threshold (160°C), so that the protective layer 11 has good thermal stability, and is not melted during production of the photovoltaic module, thereby ensuring normal production of the photovoltaic module.

Specifically, in some embodiments, the heat-resistant temperature of the protective layer 11 is 250°C (for example, a melting point of a protective layer of a PET material ranges from 250°C to 255°C) or the like.

In some embodiments, a material of the protective layer 11 includes one of a polyethylene glycol terephthalate material and a photosensitive adhesive material. When the material of the protective layer is a photosensitive adhesive material, the protective layer is formed by a cured photosensitive adhesive material; and/or a material of the bonding layer is an ethylene vinyl acetate copolymer.

In this embodiment of the present disclosure, the material of the protective layer 11 includes one of the polyethylene glycol terephthalate (PET) material and the photosensitive adhesive (ultraviolet (UV) adhesive) material. A heat-resistant temperature of the polyethylene glycol terephthalate material ranges from 250°C to 255°C (for example, 255°C), and a heat-resistant temperature of the photosensitive adhesive material is 160°C. The heat-resistant temperatures of the two materials are greater than or equal to 160°C, to avoid the following problem: Because the protective layer is prone to melting during production of the photovoltaic module, the solar cell sticks to a production device, affecting normal production of the photovoltaic module. The two materials have light transmittance greater than 95% and reliability greater than 25 years, and can satisfy performance requirements of the solar cell 10 for the light transmittance and the reliability. In addition, the material of the protective layer 11 is alternatively another material having light transmittance greater than 95%, a heat-resistant temperature greater than or equal to 160°C, and reliability greater than 25 years. The material of the bonding layer is the ethylene vinyl acetate copolymer, so that the protective layer is more firmly bonded to the light-receiving surface of the solar cell.

It should be noted that, the polyethylene glycol terephthalate material is a milky white or light yellow, highly crystalline polymer, and has a smooth and shiny surface. In a relatively wide temperature range, the polyethylene glycol terephthalate material has good physical and mechanical properties, for example, has a good electrical insulation property, still has good electrical properties even at a high temperature and a high frequency, and has good creep resistance, fatigue resistance, friction resistance, dimensional stability, organic solvent resistance, and weather resistance. The processability and physical properties of the polyethylene glycol terephthalate material can be improved by using methods such as strengthening, filling, and blending. The effect of strengthening by using glass fiber is apparent, so that stiffness, heat resistance, drug resistance, the electrical properties, and the weather resistance of the polyethylene glycol terephthalate material can be improved. Addition of a flame retardant and an anti-flame dripping agent can improve the flammability and the self-extinguishing property of the polyethylene glycol terephthalate material.

A photosensitive adhesive, also referred to as a UV adhesive, an ultraviolet adhesive, or a shadowless adhesive, is an adhesive material that can be cured only through ultraviolet irradiation. A principle of curing the photosensitive adhesive is that under ultraviolet irradiation, a photoinitiator in a UV curing material generates active radicals or cations after absorbing ultraviolet light, to initiate monomer polymerization and cross-linking chemical reactions, so that the adhesive converts from a liquid state into a solid state within several seconds. The photosensitive adhesive has high environmental protection, has no pollution to the environment, and has low flammability. A curing speed of the photosensitive adhesive is very fast, and curing can be completed within several seconds to tens of seconds by using UV curing devices with different power. This is very suitable for an automatic production line, thereby improving the production efficiency. The photosensitive adhesive has high bonding strength, and can be used for a material sensitive to a temperature, a solvent, and humidity.

In this embodiment of the present disclosure, because the photosensitive adhesive has high bonding strength, the protective layer of the photosensitive adhesive material is more firmly bonded to the bonding layer. In this way, the protective layer of the photosensitive adhesive material is more firmly bonded to the light-receiving surface of the solar cell, and the protective layer of the photosensitive adhesive material is less likely to fall off the light-receiving surface of the solar cell.

Under ultraviolet irradiation (for example, the irradiation time is 2s), the photosensitive adhesive is cured into a solid state, and the cured photosensitive adhesive forms the protective layer of the photosensitive adhesive material.

During actual production, an adhesive of an EVA material is sprayed on a film (a protective layer 11) of a polyethylene glycol terephthalate material or a photosensitive adhesive material at a high temperature and a high pressure. Heating is performed at a preset temperature (where the preset temperature ranges from 90°C to 120°C) based on heating time (where the heating time ranges from 1s to 3s), to form a bonding layer 12. Then, the protective layer 11 having the bonding layer 12 is placed on a light-receiving surface 13 of a back contact solar cell, and pressing is performed based on a pressing pressure (where the pressing pressure ranges from 30 N to 50 N), so that the protective layer 11 having the bonding layer 12 is bonded to the light-receiving surface 13 of the back contact solar cell through the bonding layer 12, to obtain the solar cell 10 provided in this embodiment of the present disclosure.

In some embodiments, the heat-resistant temperature threshold is 200°C.

It should be noted that, when the heat-resistant temperature threshold is 200°C, a material of the protective layer 11 is a polyethylene glycol terephthalate material. A heat-resistant temperature of the polyethylene glycol terephthalate material ranges from 250°C to 255°C (for example, 255°C), and the heat-resistant temperature of the polyethylene glycol terephthalate material is greater than or equal to the heat-resistant temperature threshold (200°C), to avoid the following problem: Because the protective layer is prone to melting during production of the photovoltaic module, the solar cell sticks to a production device, affecting normal production of the photovoltaic module. In addition, the material of the protective layer 11 is alternatively another material having a heat-resistant temperature greater than or equal to the heat-resistant temperature threshold (200°C).

Referring to FIG. 3, in some embodiments, a protective layer 11 is arranged on a light-receiving surface 13 of a solar cell 10. The protective layer 11 is made of a polymer material. Light transmittance of the protective layer 11 is greater than a light transmittance threshold. In addition, electrodes 15 are arranged on a back surface 14 of the solar cell 10 provided in this embodiment of the present disclosure. Types of the electrodes 15 include a positive electrode and a negative electrode.

A hardness of the protective layer 11 ranges from 55 HD to 85 HD. A thickness of the protective layer 11 ranges from 30 µm to 60 µm. A roughness of a surface of the protective layer 11 ranges from 0.4 mm to 1 mm. A heat-resistant temperature of the protective layer 11 is greater than or equal to a heat-resistant temperature threshold. The heat-resistant temperature threshold is 160°C. In some embodiments, the heat-resistant temperature threshold is 200°C; the light transmittance threshold is 95%; and the polymer material is one of polyethylene glycol terephthalate and a photosensitive adhesive.

The following three experiments are performed by using the solar cell provided in this embodiment of the present disclosure. The thickness of the protective layer of the solar cell used for the experiments is 30 µm, the material of the protective layer is the photosensitive adhesive material, and light transmittance of the photosensitive adhesive material is 98%.
(1) An adhesive layer of an adhesive of an EVA material in a lamination process during production of a photovoltaic module was arranged on the protective layer of the solar cell, to perform a tension experiment. A tension result of a tension test performed on the solar cell on which the adhesive layer of the adhesive of the EVA material was arranged was 110 N, and a tension standard required for production was not less than 70 N. Compared with a tension result (80 N to 120 N) of a tension test performed on a solar cell on which a protective layer was not arranged in the related art, the solar cell provided in this embodiment of the present disclosure satisfies the tension standard required for production, and falls within the tension result range of the tension test of the solar cell on which the protective layer was not arranged in the related art.
(2) A protective layer in this embodiment of the present disclosure was arranged in one half of a region of a light-receiving surface of a back contact solar cell, and the protective layer in this embodiment of the present disclosure was not arranged in the other half of the region, to perform an influence experiment on light transmittance. After the back contact solar cell was subjected to a lamination process during production of a photovoltaic module, observation was performed by means of naked eyes or by means of a charge coupled device (CCD) camera magnified by 30 times, and no boundary of the one half of the region of the light-receiving surface on which the protective layer in this embodiment of the present disclosure was arranged and no boundary of the other half of the region of the light-receiving surface on which the protective layer in this embodiment of the present disclosure was not arranged were found on the light-receiving surface of the back contact solar cell. Therefore, the protective layer in this embodiment of the present disclosure does not apparently affect light transmittance of the photovoltaic module generated by using the solar cell in this embodiment of the present disclosure.
   It should be noted that, the lamination process during the production of the photovoltaic module means that a glass layer, a first adhesive layer, a series group of solar cells, a second adhesive layer, and a back sheet that are stacked are placed in a laminating machine, and the module is evacuated. Then, the first adhesive layer and the second adhesive layer are melted through heating, to bond the glass layer, the series group of solar cells, and the back sheet together, to form the photovoltaic module. Both the first adhesive layer and the second adhesive layer are adhesives of EVA materials.
(3) A power experiment was performed on a solar cell provided in this embodiment of the present disclosure and a solar cell in the related art. To be specific, a power test was separately performed on the solar cell provided in this embodiment of the present disclosure and the solar cell in the related art. A power test result of the solar cell provided in this embodiment of the present disclosure was 433 W, and a power test result of the solar cell in the related art was 435 W. Therefore, power performance of the solar cell provided in this embodiment of the present disclosure is not apparently different from power performance of the solar cell in the related art.

From the perspective of a material type of the solar cell, the solar cell provided in this embodiment of the present disclosure is generally a monocrystalline silicon solar cell. Photoelectric conversion efficiency of the monocrystalline silicon solar cell can reach 28.7%. In addition, the solar cell provided in this embodiment of the present disclosure is alternatively a heterojunction solar cell. Photoelectric conversion efficiency of the heterojunction solar cell can reach 29.4%.

Referring to FIG. 4, an embodiment of the present disclosure further provides a photovoltaic module, including the foregoing solar cell 10.

In this embodiment of the present disclosure, the photovoltaic module includes, according to an order from a front surface to a back surface, a glass layer 21, a first adhesive layer 22, a series group of solar cells 10, a second adhesive layer 23, a back sheet 24, and an outer frame 25. Because the solar cell forms a complete interface with the first adhesive layer and the glass layer, this satisfies a requirement for light transmittance, and a protective layer does not need to be removed, thereby improving production efficiency. The solar cell 10 provided in the present disclosure is a back contact solar cell. A bonding layer 12 and a protective layer 11 are sequentially arranged on a light-receiving surface 13 of the solar cell 10. Light transmittance of the protective layer 11 is greater than a light transmittance threshold. A first surface 111 of the protective layer 11 is bonded to a first surface 121 of the bonding layer 12, and a second surface 122 of the bonding layer 12 is bonded to the light-receiving surface 13 of the solar cell 10. Because the protective layer 11 covers the light-receiving surface 13 of the solar cell 10, the light-receiving surface 13 of the solar cell 10 can be prevented from being scratched due to stacked transportation of the solar cells 10, and a separator paper does not need to be placed between two adjacent solar cells 10. In this way, a failure rate of the production line is reduced, and the following problem is resolved: During production of the photovoltaic module in the related art, the separator paper is placed between two adjacent solar cells 10 to prevent the light-receiving surface 13 of the solar cell 10 from being scratched due to stacked transportation of the solar cells 10, causing a failure because the separator paper is brought into the production line.

A method for packaging a solar cell provided in the embodiments of the present disclosure is described below through specific embodiments and application scenarios thereof with reference to the accompanying drawings.

FIG. 5 is a flowchart of steps of a method for packaging a solar cell according to an embodiment of the present disclosure. As shown in FIG. 5, the method includes the following steps.

Step 101: Form a coating on a light-receiving surface of a solar cell, a material of the coating being a polymer material.

Light transmittance of the polymer material is greater than a light transmittance threshold. A heat-resistant temperature of the polymer material is greater than or equal to a heat-resistant temperature threshold.

In this embodiment of the present disclosure, the coating is formed on the light-receiving surface of the solar cell, and then the coating is cured, to form a protective layer of the light-receiving surface of the solar cell.

It should be noted that, the solar cell is a back contact solar cell. The back contact solar cell has a light-receiving surface and a back surface. The light-receiving surface is a surface that is of the back contact solar cell and that absorbs sunlight, that is, a front surface of the back contact solar cell. The back surface is a back surface of the back contact solar cell, and all electrodes of the back contact solar cell are arranged on the back surface.

The polymer material includes a polyethylene glycol terephthalate (PET) material, a photosensitive adhesive (ultraviolet (UV) adhesive) material, or the like. The polyethylene glycol terephthalate material is a milky white or light yellow, highly crystalline polymer, and has a smooth and shiny surface. In a relatively wide temperature range, the polyethylene glycol terephthalate material has good physical and mechanical properties, for example, has a good electrical insulation property, still has good electrical properties even at a high temperature and a high frequency, and has good creep resistance, fatigue resistance, friction resistance, dimensional stability, organic solvent resistance, and weather resistance. The processability and physical properties of the polyethylene glycol terephthalate material can be improved by using methods such as strengthening, filling, and blending. The effect of strengthening by using glass fiber is apparent, so that stiffness, heat resistance, drug resistance, the electrical properties, and the weather resistance of the polyethylene glycol terephthalate material can be improved. Addition of a flame retardant and an anti-flame dripping agent can improve the flammability and the self-extinguishing property of the polyethylene glycol terephthalate material.

A photosensitive adhesive, also referred to as a UV adhesive, an ultraviolet adhesive, or a shadowless adhesive, is an adhesive material that can be cured only through ultraviolet irradiation. A principle of curing the photosensitive adhesive is that under ultraviolet irradiation, a photoinitiator in a UV curing material generates active radicals or cations after absorbing ultraviolet light, to initiate monomer polymerization and cross-linking chemical reactions, so that the adhesive converts from a liquid state into a solid state within several seconds. The photosensitive adhesive has high environmental protection, has no pollution to the environment, and has low flammability. A curing speed of the photosensitive adhesive is very fast, and curing can be completed within several seconds to tens of seconds by using UV curing devices with different power. This is very suitable for an automatic production line, thereby improving the production efficiency. The photosensitive adhesive has high bonding strength, and can be used for a material sensitive to a temperature, a solvent, and humidity.

The heat-resistant temperature of the polymer material is a melting point of the polymer material. When a temperature of the polymer material is greater than the heat-resistant temperature of the polymer material, the polymer material is melted into a liquid state.

Step 102: Cure the coating, to form the protective layer of the light-receiving surface of the solar cell.

In this embodiment of the present disclosure, the coating is cured, to form the protective layer of the light-receiving surface of the solar cell, thereby effectively protecting the light-receiving surface of the solar cell.

It should be noted that, the coating is in the liquid state before the curing, and the coating is in the solid state after the curing.

In conclusion, in this embodiment of the present disclosure, a solar cell is a back contact solar cell. A coating is formed on a light-receiving surface of the solar cell, a material of the coating being a polymer material. Light transmittance of the polymer material is greater than a light transmittance threshold. A heat-resistant temperature of the polymer material is greater than or equal to a heat-resistant temperature threshold. The coating is cured to form a protective layer of the light-receiving surface of the solar cell, so that a possibility that the light-receiving surface of the solar cell is scratched due to stacked transportation of solar cells is reduced, and an operator does not need to place a separator paper between two adjacent solar cells. In this way, a failure rate of a production line is reduced, and the following problem is resolved: The operator places the separator paper between two adjacent solar cells to reduce the possibility that the light-receiving surface of the solar cell is scratched due to stacked transportation of the solar cells, causing a failure because the separator paper is brought into the production line.

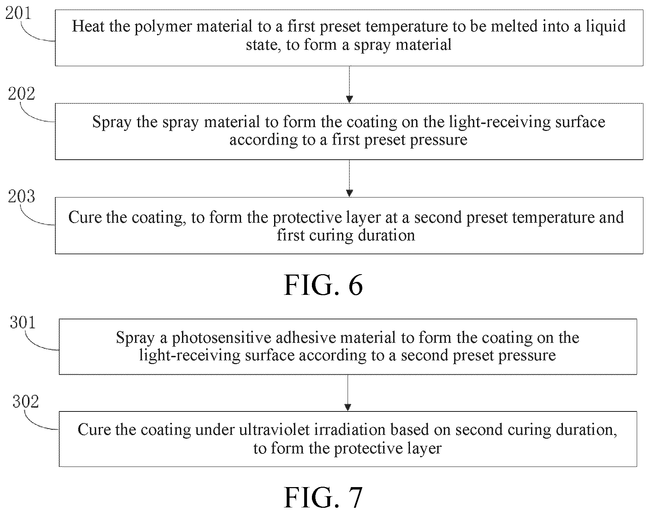

FIG. 6 is a flowchart of specific steps of a method for packaging a solar cell according to an embodiment of the present disclosure. As shown in FIG. 6, the method includes the following steps.

Step 201: Heat the polymer material to a first preset temperature to be melted into a liquid state, to form a spray material. The first preset temperature is greater than the heat-resistant temperature.

In this embodiment of the present disclosure, the polymer material is heated to the first preset temperature to be melted into the liquid state, to form the spray material. Further, the spray material is sprayed to form the coating on the light-receiving surface according to a first preset pressure.

In some embodiments, the polymer material is polyethylene glycol terephthalate.

In this embodiment of the present disclosure, the polyethylene glycol terephthalate material is heated to the first preset temperature to be melted into the liquid state, to form the spray material. Further, the spray material is sprayed to form the coating on the light-receiving surface according to the first preset pressure.

Step 202: Spray the spray material to form the coating on the light-receiving surface according to the first preset pressure.

In this embodiment of the present disclosure, the spray material is sprayed to form the coating on the light-receiving surface according to the first preset pressure.

It should be noted that, the to-be-sprayed spray material is located in a closed cavity, and is sprayed in an atomized state through a spray nozzle, to be attached to the light-receiving surface of the solar cell. The first preset pressure is a pressure at which a spraying layer is sprayed from the spray nozzle. Under the first preset pressure, the liquid spray material is atomized.

In some embodiments, the heat-resistant temperature is 255°C. The first preset pressure ranges from 0.4 kilogram-force to 0.6 kilogram-force.

In this embodiment of the present disclosure, when the spraying layer is heated to the first preset temperature and the first preset temperature is greater than the heat-resistant temperature (255°C), the spraying layer of the polyethylene glycol terephthalate material is melted into the liquid state at the first preset temperature, and then the spraying layer is atomized and sprayed to form the coating of the polyethylene glycol terephthalate material on the light-receiving surface of the solar cell according to the first preset pressure.

Specifically, in some embodiments, the first preset temperature is 260°C, 270°C, 280°C, 290°C, 300°C, 310°C, 320°C, 330°C, 340°C, or the like. The first preset pressure is 0.42 kilogram-force, 0.44 kilogram-force, 0.46 kilogram-force, 0.48 kilogram-force, 0.50 kilogram-force, 0.52 kilogram-force, 0.54 kilogram-force, 0.56 kilogram-force, 0.58 kilogram-force, 0.60 kilogram-force, or the like.

It should be noted that, kilogram-force is kilogram-weight, and is common unit of force. An international unit of force is N. One kilogram force refers to gravity exerted on an object weighting one kilogram. One kilogram force is approximately equal to 9.8 N. A heat-resistant temperature of the polymer material is 255°C, for example, a heat-resistant temperature of polyethylene glycol terephthalate is 255°C.

In some embodiments, step 202 includes the following substep.

Substep 2021: Spray the spray material on the light-receiving surface according to the first preset pressure, and form the spray material on the light-receiving surface as the coating when a thickness of the spray material on the light-receiving surface falls within a thickness range.

The thickness range is 30 µm to 60 µm.

In this embodiment of the present disclosure, the spray material is sprayed on the light-receiving surface according to the first preset pressure, and the spray material on the light-receiving surface is formed as the coating when the thickness of the spray material on the light-receiving surface falls within the thickness range (30 µm to 60 µm).

Specifically, in some embodiments, the thickness of the spray material on the light-receiving surface is 30 µm, 35 µm, 40 µm, 45 µm, 50 µm, 55 µm, 60 µm, or the like.

Step 203: Cure the coating, to form the protective layer at a second preset temperature and first curing duration.

The first curing duration ranges from 10s to 15s, and the second preset temperature ranges from 5°C to 15°C.

In this embodiment of the present disclosure, the coating is cured, that is, the liquid coating of the polyethylene glycol terephthalate material is cooled, so that the liquid coating becomes a solid coating. Specifically, the liquid coating is cooled at the second preset temperature for the first curing duration, to form a solid protective layer.

It should be noted that, the coating is usually cooled through air, to implement curing. The first curing duration is 10s, 11s, 12s, 13s, 14s, 15s, or the like. The second preset temperature is 5°C, 6°C, 7°C, 8°C, 9°C, 10°C, 11°C, 12°C, 13°C, 14°C, 15°C, or the like.

Step 201 to step 203 are performed, so that the possibility that the light-receiving surface of the solar cell is scratched due to stacked transportation of the solar cells is reduced, and the operator does not need to place a separator paper between two adjacent solar cells. In this way, a failure rate of the production line is reduced, and the following problem is resolved: The operator places the separator paper between two adjacent solar cells to reduce the possibility that the light-receiving surface of the solar cell is scratched due to stacked transportation of the solar cells, causing a failure because the separator paper is brought into the production line.

In some embodiments, step 203 is replaced with the following step (step 204).

Step 204: Cure the coating, and determine that the coating is formed as the protective layer when a hardness of a surface of the coating formed in a solid state falls within a hardness range and a thickness of the coating formed in the solid state falls within a thickness range. The hardness range is 55 HD to 85 HD. The thickness range is 30 µm to 60 µm.

In this embodiment of the present disclosure, after the coating is cured, because the hardness of the surface of the coating formed in the solid state falls within the hardness range (55 HD to 85 HD), the effectiveness of protecting the light-receiving surface of the solar cell by the protective layer can be ensured. Because the thickness of the coating formed in the solid state falls within the thickness range (30 µm to 60 µm), the protective layer is thinned, thereby satisfying a requirement for thinning the solar cell.

It should be noted that, Shore Hardness refers to a reading of a value measured by using a Shore durometer, and a unit thereof is "degree". Shore Hardness is divided into multiple manners, for example, a Shore A durometer, whose measurement range is 0 HA to 100 HA; and a Shore D durometer, whose measurement range is 0 HD to 100 HD.

Specifically, in some embodiments, the hardness of the surface of the coating formed in the solid state is measured by using the Shore D durometer. The hardness of the surface of the coating formed in the solid state is 55 HD, 60 HD, 65 HD, 70 HD, 75 HD, 80 HD, 85 HD, or the like. The thickness of the coating is 30 µm, 35 µm, 40 µm, 45 µm, 50 µm, 55 µm, 60 µm, or the like.

In some embodiments, step 203 is replaced with the following steps (step 205 and step 206).

Step 205: Cure the coating, and determine a roughness of a surface of the coating formed in a solid state when it is determined that a hardness of the surface of the coating formed in the solid state falls within a hardness range and a thickness of the coating formed in the solid state falls within a thickness range. The hardness range is 55 HD to 85 HD. The thickness range is 30 µm to 60 µm.

In this embodiment of the present disclosure, after the coating is cured, because the hardness of the surface of the coating formed in the solid state falls within the hardness range (55 HD to 85 HD), the effectiveness of protecting the light-receiving surface of the solar cell by the protective layer formed by the coating can be ensured. Because the thickness of the coating formed in the solid state falls within the thickness range (30 µm to 60 µm), the protective layer formed by the coating is thinned, thereby satisfying a requirement for thinning the solar cell. When it is determined that the hardness of the surface of the coating formed in the solid state falls within the hardness range and the thickness of the coating formed in the solid state falls within the thickness range, the roughness of the surface of the coating formed in the solid state needs to be determined, to further determine whether the roughness of the surface of the coating formed in the solid state falls within a roughness range.

Step 206: Determine that the coating is formed as the protective layer when the roughness of the surface of the coating formed in the solid state falls within the roughness range.

The roughness range is 0.4 mm to 1 mm.

In this embodiment of the present disclosure, when it is determined that the hardness of the surface of the coating formed in the solid state falls within the hardness range and the thickness of the coating formed in the solid state falls within the thickness range, after the roughness of the surface of the coating formed in the solid state is determined, the roughness of the surface of the coating formed in the solid state is judged. When the roughness of the surface of the coating formed in the solid state falls within the roughness range (0.4 mm to 1 mm), it is determined that the coating is formed as the protective layer. In a lamination process during production of a photovoltaic module, an adhesive layer of an adhesive of an EVA material is arranged on the protective layer of the solar cell, to bond the solar cell to a glass sheet. Because the roughness of the surface of the coating formed in the solid state falls within the roughness range (0.4 mm to 1 mm), a roughness of a surface of the protective layer formed by the coating falls within the roughness range (0.4 mm to 1 mm). In this way, it is ensured that an interface formed by contact between the surface of the protective layer formed by the coating and the adhesive layer of the adhesive can reduce a degree of specular reflection generated on light, thereby improving light transmittance.

It should be noted that, the adhesive of the EVA material is an EVA composite adhesive. The EVA composite adhesive is a type of glue. Main components of the EVA composite adhesive are thermal plastic styrene-butadiene rubber, rosin modified resin, petroleum resin, and a solvent. The EVA composite adhesive has a good bonding effect and long aging time, does not need to process water, and is applied once, so that the EVA composite adhesive is more conveniently used, and the production efficiency is higher. A curing object bonded by using the EVA composite adhesive has super strong flexibility, can bear severe beating and falling, and is not easy to flake off, so that the EVA composite adhesive has a good cushioning property. The EVA composite adhesive has a low odor, and satisfies an environmental protection standard and a health standard. In addition, the EVA composite adhesive has high strength, high transparency, and high initial adhesion.

Specifically, in some embodiments, the roughness is 0.4 mm, 0.5 mm, 0.6 mm, 0.7 mm, 0.8 mm, 0.9 mm, 1.0 mm, or the like.

Step 205 and step 206 are performed, so that the coating is cured, and the coating is formed as the protective layer. Because the hardness of the surface of the coating formed in the solid state falls within the hardness range (55 HD to 85 HD), the effectiveness of protecting the light-receiving surface of the solar cell by the protective layer formed by the coating can be ensured. Because the thickness of the coating formed in the solid state falls within the thickness range (30 µm to 60 µm), the protective layer formed by the coating is thinned, thereby satisfying a requirement for thinning the solar cell. Because the roughness of the surface of the coating formed in the solid state falls within the roughness range (0.4 mm to 1 mm), it is ensured that an interface formed by contact between the surface of the protective layer formed by the coating and the adhesive layer of the adhesive can reduce a degree of specular reflection generated on light, thereby improving light transmittance.

In some embodiments, the light transmittance threshold is 95%.

In this embodiment of the present disclosure, because the light transmittance of the protective layer of the solar cell is greater than the light transmittance threshold (95%), it can be ensured that the solar cell can normally receive solar energy to normally operate.

In some embodiments, the heat-resistant temperature threshold is 160°C.

In this embodiment of the present disclosure, the heat-resistant temperature is greater than or equal to the heat-resistant temperature threshold (160°C), to avoid the following problem: Because the protective layer is prone to melting during production of the photovoltaic module, the solar cell sticks to a production device, affecting normal production of the photovoltaic module.

It should be noted that, a material of the protective layer is a polyethylene glycol terephthalate material or a photosensitive adhesive material. Light transmittance of the polyethylene glycol terephthalate material and light transmittance of the photosensitive adhesive material are greater than 95%, and reliability of the polyethylene glycol terephthalate material and reliability of the photosensitive adhesive material are greater than 25 years, which can satisfy performance requirements of the solar cell for light transmittance and reliability. A heat-resistant temperature of the polyethylene glycol terephthalate material ranges from 250°C to 255°C (for example, 255°C), and a heat-resistant temperature of the photosensitive adhesive material is 160°C. The heat-resistant temperature of the polyethylene glycol terephthalate material and the heat-resistant temperature of the photosensitive adhesive material are greater than or equal to the heat-resistant temperature threshold (160°C), to avoid the following problem: Because the protective layer is prone to melting during production of the photovoltaic module, the solar cell sticks to a production device, affecting normal production of the photovoltaic module. In addition, the material of the protective layer is alternatively another material having light transmittance greater than 95%, reliability greater than 25 years, and a heat-resistant temperature greater than or equal to the heat-resistant temperature threshold (160°C).

In some embodiments, the heat-resistant temperature threshold is 200°C.

It should be noted that, when the heat-resistant temperature threshold is 200°C, a material of the protective layer is a polyethylene glycol terephthalate material. A heat-resistant temperature of the polyethylene glycol terephthalate material ranges from 250°C to 255°C (for example, 255°C), and the heat-resistant temperature of the polyethylene glycol terephthalate material is greater than or equal to the heat-resistant temperature threshold (200°C), to avoid the following problem: Because the protective layer is prone to melting during production of the photovoltaic module, the solar cell sticks to a production device, affecting normal production of the photovoltaic module. In addition, the material of the protective layer is alternatively another material having a heat-resistant temperature greater than or equal to the heat-resistant temperature threshold (200°C).

The protective layer of the solar cell in this embodiment of the present disclosure is a transparent protective layer. No bubble exists inside the protective layer of the solar cell in this embodiment of the present disclosure.

FIG. 7 is a flowchart of specific steps of another method for packaging a solar cell according to an embodiment of the present disclosure. As shown in FIG. 7, the method includes the following steps.

Step 301: Spray the photosensitive adhesive material to form the coating on the light-receiving surface according to a second preset pressure. The second preset pressure ranges from 0.4 kilogram-force to 0.6 kilogram-force.

In this embodiment of the present disclosure, the polymer material is the photosensitive adhesive material. Because the photosensitive adhesive is in the liquid state at an ordinary temperature (where the ordinary temperature ranges from 20°C to 30°C), the liquid photosensitive adhesive material is sprayed to form the coating on the light-receiving surface according to the second preset pressure.

It should be noted that, the to-be-sprayed photosensitive adhesive material is located in a closed cavity, and is sprayed in an atomized state through a spray nozzle, to be attached to the light-receiving surface of the solar cell. The second preset pressure is a pressure at which a spraying layer is sprayed from the spray nozzle. Under the second preset pressure, the liquid photosensitive adhesive material is atomized.

Specifically, in some embodiments, the second preset pressure is 0.42 kilogram-force, 0.44 kilogram-force, 0.46 kilogram-force, 0.48 kilogram-force, 0.50 kilogram-force, 0.52 kilogram-force, 0.54 kilogram-force, 0.56 kilogram-force, 0.58 kilogram-force, 0.60 kilogram-force, or the like.

Step 302: Cure the coating under ultraviolet irradiation based on second curing duration, to form the protective layer. The second curing duration ranges from 2s to 3s.

In this embodiment of the present disclosure, the coating of the photosensitive adhesive material is cured, that is, the coating of the photosensitive adhesive material is irradiated with ultraviolet light. Because the photosensitive adhesive material is cured under ultraviolet irradiation, the liquid coating of the photosensitive adhesive material becomes a solid coating under ultraviolet irradiation. Specifically, the coating of the photosensitive adhesive material is irradiated with ultraviolet light for the second curing duration, to form the solid protective layer.

It should be noted that, usually, the coating of the photosensitive adhesive material is irradiated by using a lamp emitting ultraviolet light.

Specifically, in some embodiments, the second curing duration is 2s, 2.5s, 3s, or the like.

Step 301 to step 302 are performed, so that the possibility that the light-receiving surface of the solar cell is scratched due to stacked transportation of the solar cells is reduced, and the operator does not need to place a separator paper between two adjacent solar cells. In this way, a failure rate of the production line is reduced, and the following problem is resolved: The operator places the separator paper between two adjacent solar cells to reduce the possibility that the light-receiving surface of the solar cell is scratched due to stacked transportation of the solar cells, causing a failure because the separator paper is brought into the production line.

In some embodiments, step 301 is replaced with the following step (step 303).

Step 303: Print the photosensitive adhesive material to form the coating on the light-receiving surface according to a third preset pressure through screen printing.

The third preset pressure ranges from 50 N to 60 N.

In this embodiment of the present disclosure, the polymer material is the photosensitive adhesive material. Because the photosensitive adhesive is in the liquid state at an ordinary temperature (where the ordinary temperature ranges from 20°C to 30°C), the photosensitive adhesive material is printed to form the coating on the light-receiving surface of the solar cell according to the third preset pressure through screen printing, and then the coating is cured to form the protective layer.

It should be noted that, a process of arranging the coating of the photosensitive adhesive material on the light-receiving surface of the solar cell through screen printing is as follows: A screen printing plate is placed on the light-receiving surface of the solar cell, so that a bottom surface of the screen printing plate comes into contact with the light-receiving surface of the solar cell. Then, the photosensitive adhesive material is placed at one end of a top surface of the screen printing plate, the third preset pressure is applied to the photosensitive adhesive material at the one end of the top surface of the screen printing plate by using a scraper, and at the same time, uniform movement is performed toward the other end of the top surface of the screen printing plate. During the movement, the photosensitive adhesive material is pressed, by the scraper, from meshes of the screen printing plate to the light-receiving surface of the solar cell. So far, the coating of the photosensitive adhesive material is arranged on the light-receiving surface of the solar cell.

Specifically, in some embodiments, the third preset pressure is 50 N, 52 N, 54 N, 56 N, 58 N, 60 N, or the like.

In some embodiments, step 302 is replaced with the following step (step 304).

Step 304: Cure the coating, and form the coating as the protective layer when a hardness of a surface of the coating formed in a solid state falls within a hardness range and a thickness of the coating formed in the solid state falls within a thickness range.

The hardness range is 55 HD to 85 HD. The thickness range is 30 µm to 60 µm.

An implementation of this step is similar to an implementation process of step 204. Details are not described herein again.

In some embodiments, step 302 is replaced with the following steps (step 305 and step 306).

Step 305: Cure the coating, and determine a roughness of a surface of the coating formed in a solid state when it is determined that a hardness of the surface of the coating formed in the solid state falls within a hardness range and a thickness of the coating formed in the solid state falls within a thickness range.

The hardness range is 55 HD to 85 HD. The thickness range is 30 µm to 60 µm.

An implementation of this step is similar to an implementation process of step 205. Details are not described herein again.

Step 306: Form the coating as the protective layer when the roughness of the surface of the coating formed in the solid state falls within a roughness range.

The roughness range is 0.4 mm to 1 mm.

An implementation of this step is similar to an implementation process of step 206. Details are not described herein again.

In some embodiments, the light transmittance threshold is 95%.

In this embodiment of the present disclosure, because the light transmittance of the protective layer of the solar cell is greater than the light transmittance threshold (95%), it can be ensured that the solar cell can normally receive solar energy to normally operate.

In some embodiments, the heat-resistant temperature threshold is 160°C.

In this embodiment of the present disclosure, the heat-resistant temperature is greater than or equal to the heat-resistant temperature threshold (160°C), to avoid the following problem: Because the protective layer is prone to melting during production of the photovoltaic module, the solar cell sticks to a production device, affecting normal production of the photovoltaic module.

It should be noted that, a material of the protective layer is a polyethylene glycol terephthalate material or a photosensitive adhesive material. Light transmittance of the polyethylene glycol terephthalate material and light transmittance of the photosensitive adhesive material are greater than 95%, and reliability of the polyethylene glycol terephthalate material and reliability of the photosensitive adhesive material are greater than 25 years, which can satisfy performance requirements of the solar cell for light transmittance and reliability. A heat-resistant temperature of the polyethylene glycol terephthalate material ranges from 250°C to 255°C (for example, 255°C), and a heat-resistant temperature of the photosensitive adhesive material is 160°C. The heat-resistant temperature of the polyethylene glycol terephthalate material and the heat-resistant temperature of the photosensitive adhesive material are greater than or equal to the heat-resistant temperature threshold (160°C), to avoid the following problem: Because the protective layer is prone to melting during production of the photovoltaic module, the solar cell sticks to a production device, affecting normal production of the photovoltaic module. In addition, the material of the protective layer is alternatively another material having light transmittance greater than 95%, reliability greater than 25 years, and a heat-resistant temperature greater than or equal to the heat-resistant temperature threshold (160°C).

In some embodiments, the heat-resistant temperature threshold is 200°C.

It should be noted that, when the heat-resistant temperature threshold is 200°C, a material of the protective layer is a polyethylene glycol terephthalate material. A heat-resistant temperature of the polyethylene glycol terephthalate material ranges from 250°C to 255°C (for example, 255°C), and the heat-resistant temperature of the polyethylene glycol terephthalate material is greater than or equal to the heat-resistant temperature threshold (200°C), to avoid the following problem: Because the protective layer is prone to melting during production of the photovoltaic module, the solar cell sticks to a production device, affecting normal production of the photovoltaic module. In addition, the material of the protective layer is alternatively another material having a heat-resistant temperature greater than or equal to the heat-resistant temperature threshold (200°C).

The protective layer of the solar cell in this embodiment of the present disclosure is a transparent protective layer. No bubble exists inside the protective layer of the solar cell in this embodiment of the present disclosure.

In some embodiments, the method for packaging a solar cell provided in this embodiment of the present disclosure includes: A protective layer is arranged on a light-receiving surface of a solar cell. Light transmittance of the protective layer is greater than a light transmittance threshold. A heat-resistant temperature of the protective layer is greater than or equal to a heat-resistant temperature threshold. The protective layer is a film, and a material of the protective layer is a polyethylene glycol terephthalate material or a photosensitive adhesive material. That a protective layer is arranged on a light-receiving surface of a solar cell includes: The protective layer is obtained, and a bonding layer is formed on the protective layer. The protective layer is arranged on the light-receiving surface of the solar cell through the bonding layer.

It should be noted that, that a bonding layer is formed on the protective layer includes: An adhesive is sprayed to form an adhesive coating on the protective layer. The adhesive coating is heated to form the bonding layer at a third preset temperature and preset duration. That the protective layer is arranged on the light-receiving surface of the solar cell through the bonding layer includes: The protective layer is placed on the light-receiving surface of the solar cell through the bonding layer, to cause the bonding layer to be arranged between the protective layer and the light-receiving surface of the solar cell. The protective layer is pressed based on a pressing pressure, to cause the protective layer to be bonded to the light-receiving surface of the solar cell through the bonding layer. The preset duration ranges from 1s to 3s. The third preset temperature ranges from 90°C to 120°C. The pressing pressure ranges from 30 N to 50 N.

In conclusion, because a protective layer covers a light-receiving surface of a solar cell, the light-receiving surface of the solar cell can be prevented from being scratched due to stacked transportation of solar cells, and a separator paper does not need to be placed between two adjacent solar cells, reducing a failure rate of a production line.

Although the embodiments of the present disclosure are described above with reference to the accompanying drawings, the present disclosure is not limited to the foregoing specific embodiments and application fields. The foregoing specific embodiments are only exemplary and instructive rather than restrictive. Enlightened by the present disclosure, a person of ordinary skill in the art can make many forms without departing from the scope of protection of the claims of the present disclosure. All of the forms fall within the protection of the present disclosure.

## Claims

1. A solar cell (10), wherein the solar cell (10) is a back contact solar cell, wherein a protective layer (11) is arranged on a light-receiving surface (13) of the solar cell (10), light transmittance of the protective layer (11) being greater than a light transmittance threshold; and a heat-resistant temperature of the protective layer (11) being greater than or equal to a heat-resistant temperature threshold.

2. The solar cell (10) according to claim 1, wherein a bonding layer (12) is arranged between the protective layer (11) and the light-receiving surface (13) of the solar cell (10); and
a first surface (111) of the protective layer (11) is bonded to a first surface (121) of the bonding layer (12), and a second surface (122) of the bonding layer (12) is bonded to the light-receiving surface (13) of the solar cell (10).

3. The solar cell (10) according to claim 2, wherein the bonding layer (12) comprises a plurality of bonding parts, the bonding parts being distributed in an entire region or a partial region of the light-receiving surface (13).

4. The solar cell (10) according to claim 2, wherein a thickness range of the bonding layer (12) is 5 µm to 10 µm.

5. The solar cell (10) according to claim 1, wherein a material of the protective layer (11) is one of a polyethylene glycol terephthalate material and a photosensitive adhesive material.

6. The solar cell (10) according to claim 2, wherein when a material of the protective layer (11) is a photosensitive adhesive material, the protective layer (11) is formed by a cured photosensitive adhesive material; and/or
a material of the bonding layer (12) is an ethylene vinyl acetate copolymer.

7. The solar cell (10) according to claim 1, wherein at least one surface of the protective layer (11) is a frosted surface;
a thickness of the protective layer (11) ranges from 30 µm to 60 µm; and
a roughness of a first surface (111) of the protective layer (11) ranges from 0.4 mm to 1.0 mm; and/or a roughness of a second surface (112) of the protective layer (11) ranges from 0.4 mm to 1.0 mm.

8. The solar cell (10) according to claim 1, wherein a hardness of the protective layer (11) ranges from 55 HD to 85 HD; and
the light transmittance threshold is 95%; and/or the heat-resistant temperature threshold is 160°C or 200°C.

9. A photovoltaic module, comprising the solar cell (10) according to any one of claims 1 to 8.

10. A method for packaging a solar cell (10), a solar cell (10) being a back contact solar cell, the method comprising: arranging a protective layer (11) on a light-receiving surface (13) of the solar cell (10), light transmittance of the protective layer (11) being greater than a light transmittance threshold; and a heat-resistant temperature of the protective layer (11) being greater than or equal to a heat-resistant temperature threshold.

11. The method according to claim 10, wherein the arranging a protective layer (11) on a light-receiving surface (13) of the solar cell (10) comprises:
forming a coating on the light-receiving surface (13) of the solar cell (10), a material of the coating being a polymer material, light transmittance of the polymer material being greater than the light transmittance threshold, and a heat-resistant temperature of the polymer material being greater than or equal to the heat-resistant temperature threshold; and
curing the coating, to form the protective layer (11) of the light-receiving surface (13) of the solar cell (10).

12. The method according to claim 11, wherein the forming a coating on the light-receiving surface (13) of the solar cell (10) comprises:
heating the polymer material to a first preset temperature to be melted into a liquid state, to form a spray material, the first preset temperature being greater than the heat-resistant temperature; and
spraying the spray material to form the coating on the light-receiving surface (13) according to a first preset pressure, wherein
the heat-resistant temperature is 255°C; and the first preset pressure ranges from 0.4 kilogram-force to 0.6 kilogram-force.

13. The method according to claim 11 or 12, wherein the curing the coating, to form the protective layer (11) of the light-receiving surface (13) of the solar cell (10) comprises:
curing the coating, to form the protective layer (11) at a second preset temperature and first curing duration, wherein
the first curing duration ranges from 10s to 15s, and the second preset temperature ranges from 5°C to 15°C.

14. The method according to claim 12, wherein the spraying the spray material to form the coating on the light-receiving surface (13) according to a first preset pressure comprises:
spraying the spray material on the light-receiving surface (13) according to the first preset pressure, and forming the spray material on the light-receiving surface (13) as the coating when a thickness of the spray material on the light-receiving surface (13) falls within a thickness range, wherein
the thickness range is 30 µm to 60 µm.

15. The method according to claim 11, wherein the polymer material is a photosensitive adhesive material; and the forming a coating on the light-receiving surface (13) of the solar cell (10) comprises:
spraying the photosensitive adhesive material to form the coating on the light-receiving surface (13) according to a second preset pressure, the second preset pressure ranging from 0.4 kilogram-force to 0.6 kilogram-force;
or
printing the photosensitive adhesive material to form the coating on the light-receiving surface (13) according to a third preset pressure through screen printing, the third preset pressure ranging from 50 N to 60 N.

16. The method according to claim 15, wherein the curing the coating, to form the protective layer (11) of the light-receiving surface (13) of the solar cell (10) comprises:
curing the coating under ultraviolet irradiation based on second curing duration, to form the protective layer (11), the second curing duration ranging from 2s to 3s.

17. The method according to claim 11, wherein the curing the coating, to form the protective layer (11) of the light-receiving surface (13) of the solar cell (10) comprises:
curing the coating, and forming the coating as the protective layer (11) when a hardness of a surface of the coating formed in a solid state falls within a hardness range and a thickness of the coating formed in the solid state falls within a thickness range;
or
curing the coating, and determining a roughness of a surface of the coating formed in a solid state when it is determined that a hardness of the surface of the coating formed in the solid state falls within a hardness range and a thickness of the coating formed in the solid state falls within a thickness range; and forming the coating as the protective layer (11) when the roughness of the surface of the coating formed in the solid state falls within a roughness range,
wherein
the hardness range is 55 HD to 85 HD; the thickness range is 30 µm to 60 µm; and the roughness range is 0.4 mm to 1 mm.

18. The method according to claim 10, wherein the protective layer (11) is a film, and a material of the protective layer (11) is a polyethylene glycol terephthalate material or a photosensitive adhesive material; and the arranging a protective layer (11) on a light-receiving surface (13) of the solar cell (10) comprises:
obtaining the protective layer (11), and forming a bonding layer (12) on the protective layer (11); and
arranging the protective layer (11) on the light-receiving surface (13) of the solar cell (10) through the bonding layer (12).

19. The method according to claim 18, wherein the forming a bonding layer (12) on the protective layer (11) comprises:
spraying an adhesive to form an adhesive coating on the protective layer (11); and
heating the adhesive coating to form the bonding layer (12) at a third preset temperature and preset duration, wherein
the preset duration ranges from 1s to 3s, and the third preset temperature ranges from 90°C to 120°C.

20. The method according to claim 18, wherein the arranging the protective layer (11) on the light-receiving surface (13) of the solar cell (10) through the bonding layer (12) comprises:
placing the protective layer (11) on the light-receiving surface (13) of the solar cell (10) through the bonding layer (12), to cause the bonding layer (12) to be arranged between the protective layer (11) and the light-receiving surface (13) of the solar cell (10); and
pressing the protective layer (11) based on a pressing pressure, to cause the protective layer (11) to be bonded to the light-receiving surface (13) of the solar cell (10) through the bonding layer (12), wherein
the pressing pressure ranges from 30 N to 50 N.
